# EUROPEAN PATENT SPECIFICATION

(11) **EP 4 657 085 B1**
(45) Date of publication and mention of the grant of the patent: **11.11.2026**
(21) Application number: 24179274.6
(22) Date of filing: 31.05.2024
(51) Int. Cl.: G01R 27/26, G01R 31/40, G01R 31/64, H02M 7/483

(54) **CONVERTER AND A METHOD FOR OPERATING A CONVERTER**
UMRICHTER UND VERFAHREN ZUM BETREIBEN EINES UMRICHTERS
CONVERTISSEUR ET PROCÉDÉ DE FONCTIONNEMENT D'UN CONVERTISSEUR

(43) Date of publication of application: 03.12.2025
(73) Proprietor: Siemens Energy Global GmbH & Co. KG, 81739 München (DE)
(72) Inventor: Armschat, Christoph, 91058 Erlangen (DE); Gambach, Herbert, 91080 Uttenreuth (DE); Kaytzuck, Jörg, 91058 Erlangen (DE); Stoltze, Torsten, 91074 Herzogenaurach (DE); Hoffmann, Andreas, 01069 Dresden (DE)

(56) References cited:
- CN-A- 109 001 541
- CN-A- 110 165 914
- CN-A- 111 665 393
- CN-A- 114 778 951
- KR-B1- 101 553 480

## Description

The present invention relates to a method for operating a converter, said converter comprising a switching module, wherein the switching module comprises an energy storage and semiconductor switches to alternatively allow or block current flow through said energy storage, the method comprising the steps of measuring a voltage present across said energy storage, and measuring current flowing through said energy storage.

In most of the existing converter systems a continuous monitoring of the energy storages during operation is not possible. Failures of energy storages therefore often occur as a surprise.

An exact measurement of the capacity of a converter capacitor is usually only possible when the converter is out of operation, using a capacitance measurement bridge. When determining the capacitance from voltage and current measurement during operation, several effects reducing the accuracy of the capacitance determination must be considered, including measurement offsets, disturbances and electromagnetic interference.

An afore mentioned method is known from the EP 2 100 365 B1. According to the known method a capacitor voltage across a converter capacitor and a phase module current is measured to determine a capacitance of the capacitor.

Further relevant prior art is disclosed in KR 101 553 480 B1.

The object of the invention is thus to propose an afore mentioned method that allows an effective capacitance monitoring of a converter during operation.

The object is achieved by a converter according to claim 1.

According to the invention, another step of the method is a step of determining a capacitance of said energy storage by minimizing an objective function of said voltage, said current, said capacitance and a time over minimization parameters capacitance and time. In other words, the determining of said capacitance is done via finding values of capacitance and time so that the objective function that depends on the variables voltage (across the energy storage), current (through the energy storage), capacitance, and time, reaches a minimum value. So, instead of using a forward computation e.g., by means of a given formula, the determination of the capacitance is performed as an optimization problem. In addition, instead of using capacitance as the only minimization parameter, the method of the present invention requires to also use time (or time shift) as another minimization parameter. The advantage of including time as an additional minimization parameter is that it allows to minimize error that originates from measurement time shifts. In general, measurement signals from current and voltage measurements have temporal shifts (jitter). According to own investigations, these temporal shifts cause significant errors in determining capacitances. By including time as another computational parameter, these effects can be significantly reduced.

According to an embodiment of the invention, the objective function depends on a time integral of said current. In particular, one has the following equation that generally holds for capacitance: Uc(t)-U0 = 1/C * time integral [ i(t') dt' ], where Uc is a voltage across the energy storage at time t, U0 an initial voltage, C is the capacitance and i(t') a current flowing through the energy storage at a time t'. Thus, there is a correspondence between the capacitance and the time integral of the current. In practice, the current can be integrated in accordance with known numerical integration methods (e.g., using the trapezoidal rule).

The objective function f to be minimized preferably is given by f=((Uc(t)-U0)/[1/C * int_s(i(s)ds)] - 1)^2, where int_s denotes a time integral with s as time parameter. The actual capacitance Cact can be determined via f(Cact)=min f. An advantage of the capacitance determination by means of a function optimization (minimization) has the advantage of a high accuracy even in the presence of noisy measurement signals. Note that f is by definition a non-negative function with a minimum at f=0.

According to an embodiment, the minimization parameter values lie within predefined parameter limits. A lower limit for the capacitance can for example be set to 50% of a nominal capacitance, an upper limit to 120% of the nominal capacitance. The time shift limits preferable are: zero for the lower and 100 microseconds for the upper limit. By setting proper limits implausible function minima can be avoided.

Preferably, the measured voltage and/or current values are smoothed before determining the capacity. Additionally, out-lier values can be detected and removed from the data. In this way single measurement errors (e.g., through disturbances) can be avoided.

The method can further comprise a step of identifying an offset in the measured current before determining the capacitance. The measured current usually shows an offset that has a negative influence on the determination of the capacitance. To detect and remove the offset, the current signal can be cut into segments. The measurement data originating from different segments can then be compared. In particular, it is advantageous to compare measurement segments from different switching modules in one arm of a modular multilevel converter.

Preferably the method further comprises the step of detecting an abnormal capacitance value. If an abnormal value of the capacitance is detected, a corresponding anomaly information can be provided to a monitoring system. The detection of abnormal capacitance can be done using the following approaches (alone or in combination).

The value of capacitance (of a given energy storage) at a given time is compared with capacitance values of other energy storages. For example, in a modular multilevel converter having converter arms, the capacitance values of a given energy storage are compared with capacitance values of other energy storages of the same converter arm. Since all energy storages of the same converter arm are subject to similar environmental conditions (like temperature), the comparison allows to minimize the impact of temperature and systematical measurement errors.

To detect an abnormal value, the capacitance value can be normalized, i.e., divided by a reference value recorded after commissioning ("starting value of capacitance")and then compared with a predefined threshold. This allows to avoid an error that originates from the fact that different energy storages may have different nominal maximum capacitances.

Capacitance values generally show long-term changes (also called a capacitance value drift). When detecting abnormal behavior of an energy storage, this long-term behavior may be considered. To consider the value drift, capacitance value changes over time (instead of the capacitance values themselves) may be analyzed over a long period of time (weeks or months). As an example, an indicator of an abnormal behavior of an energy storage is a decrease of the capacitance value (of a given energy storage) that is faster than a predefined decrease threshold or, alternatively, faster than an average capacitance value decrease of other energy storages. The amount of drift can for example be specified in a percentage per month.

To avoid sending a message to the monitoring system each time an anomaly is found, a threshold value for a number of consecutive anomalies can be specified that must be exceeded before the message is sent.

Preferably some or all method steps described above are repeated several times (e.g., thrice) a day. A more frequent repeat of the capacitance determination allows a more precise and reliable monitoring of the converter.

Under certain conditions the calculation of a low capacity can also result from a faulty, too high voltage measurement. In order to distinguish capacitor degrading from voltage measurement errors, the discharging process of the energy storage of a switching module with the calculated low capacity is compared with the discharging process of other switching modules in the same converter arm under comparable load conditions. If the voltage in the conspicuous switching module (with the calculated low capacity) drops significantly faster during discharging than in other submodules, a possible error in the voltage measurement can be ruled out, and it is then certain that the low capacity of the capacitor is the cause.

The present invention further relates to a converter for converting electrical power. This kind of converter may for example be used for HVDC (AC/DC or DC/DC converters) and FACTS applications. Usually, such converters comprise a plurality of semiconductor switches and at least one energy storage (e.g., a capacitor).

According to the invention, an afore-mentioned converter comprises a converter control that is configured to operate the converter in accordance with the method described above.

According to an embodiment the converter is a modular multi-level converter having a series of switching modules each comprising an energy storage (e.g., a capacitor), wherein the converter control is configured to determine a capacitance of some, preferably of all energy storages. A modular multilevel converter (MMC) comprises a series of switching modules in each of the converter arms. Each of the switching modules comprises switch-off type semiconductor switches, like e.g., IGBT, IGCT, MOSFET (including wide-gap semiconductor based switches) and an energy storage, like e.g., a capacitor. Every switching module can be individually controlled to provide certain module voltage at its terminals (e.g., the energy storage/capacitor voltage or a zero voltage in case of a half-bridge module, or the energy storage/capacitor voltage, a negative energy storage/capacitor voltage or a zero voltage in case of a full-bridge module).

The invention is explained further with reference to examples illustrated in the figures 1 to 4.
Figure 1 shows a schematic view of a converter according to an embodiment of the invention;
Figure 2 shows a schematic view of a converter according to another embodiment of the invention;
Figure 3 shows an example of a switching module for a converter according to the invention;
Figure 4 shows a flow diagram of an embodiment of the method according to the invention.

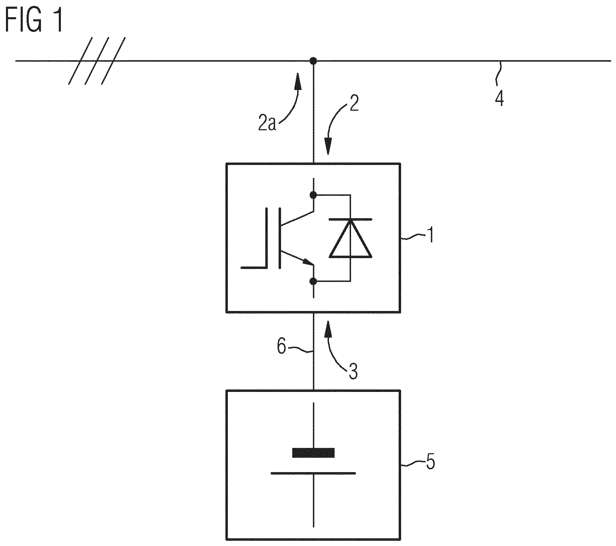

A converter 1 with an AC side 2 and a DC side 3 is depicted in figure 1. The converter 1 is a voltage source converter. The AC side 2 of the converter 1 is connected to an AC grid 4 at a connecting point 2a. The DC side 3 of the converter is connected to an electrical energy storage device 5 via a DC link 6. The converter 1 is designed to stabilize the AC grid 4 by exchanging active and reactive power with the AC grid 4.

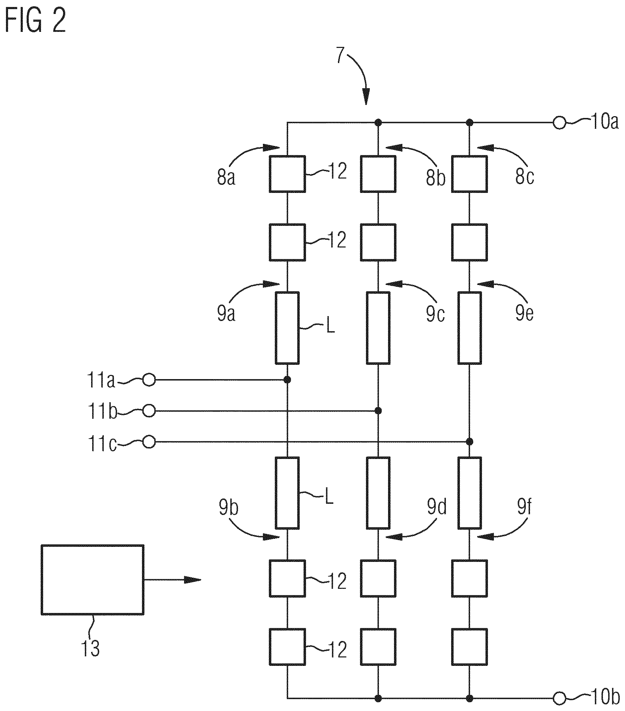

Figure 2 shows a voltage source converter being a modular multilevel converter (MMC) 7. The MMC 7 comprises three phase branches 8a-c and six converter arms 9a-f. Every converter arm 9a-f extends between one of the DC poles or terminals 10a,b, constituting a DC side of the converter 7, and one of the AC terminals 11a-c constituting an AC side of the converter 7. Each converter arm 9a-f comprises an arm inductance L and a number of switching modules 12 connected in series. The number of switching modules 12 in every converter arm 9a-f can in general be chosen to best match the needs of a given application (and is not restricted to two per arm). The switching modules 12 can for example be so-called half-bridge or full-bridge switching modules (or a combination of both). A proper control of the semiconductor switches of a full-bridge switching module 12 creates a positive, a negative or a zero voltage across its terminals. The converter 7 comprises a converter control 13 for controlling the operation of the converter 7.

The MMC 7 is suitable for grid stabilization applications (as shown in figure 1) and for high-voltage direct current energy transmission (HVDC), wherein its DC side is connected to a DC transmission line. Particularly in HVDC applications each of the converter arms can comprise full-bridge switching modules, half-bridge switching modules, other switching module topologies or any combinations thereof.

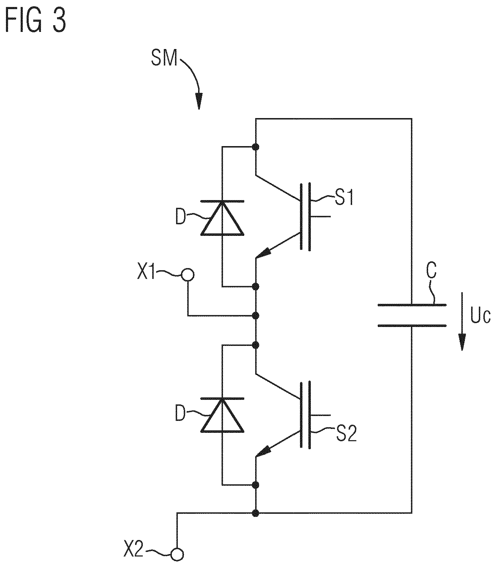

An example of a half-bridge switching module SM is shown in figure 3. The switching module SM comprises two terminals X1, X2 to connect e.g. to further, neighboring switching modules. The switching module SM further comprises two semiconductor switches S1, S2 of the turn-off type with antiparallel freewheeling diodes D. An energy storage element (capacitor) C is connected in parallel to the series connection of the semiconductor switches S1,S2. By a proper control of the switches S1, S2, the capacitor C can be bypassed (the converter current flow through the capacitor is blocked), implying a zero voltage at the terminals X1, X2. Alternatively, if a flow of the converter current through the capacitor is allowed, the voltage across the terminals X1, X2 corresponds to the capacitor voltage Uc.

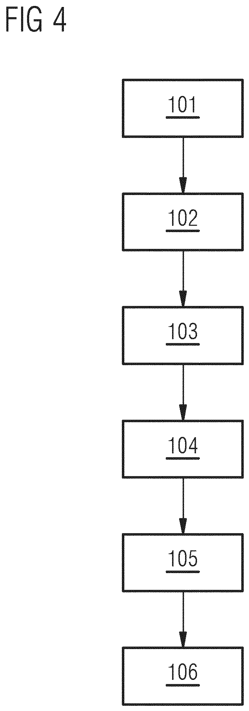

As seen from figures 1 to 3, the converter comprises a plurality of energy storages in form of capacitors. During operation of the converter the capacitances of the capacitors are monitored. The monitoring comprises a determination of a capacitance of the converter capacitors. Figure 4 shows the steps of a method to determine the capacitance of the capacitor.

The steps shown in figure 4 show the method applied to one of the energy storages. However, the operation of the converter may comprise same method steps applied to some or all its energy storages.

In a first step 101 the voltage across the capacitor and the current flowing through the capacitor are measured and the measured voltage and current values are provided to the converter control for further processing.

In a second step 102 the measured values are further processed, in particular the measured values are smoothed, and a current offset is eliminated from the measured data.

In a third step 103 determining a capacitance of said energy storage by minimizing an objective function of voltage, current, capacitance and time, i.e., using an optimization routine, values of a time variable and a capacitance variable are found, such that the objective function reaches a minimum. There are optimization routines or algorithms known form prior art that are applicable to the present method, like e.g. global optimization, e.g., controlled random search with local mutation, multi-level single-linkage, improved stochastic ranking evolution strategy, local derivative-free optimization, e.g., constrained optimization by linear approximations, local gradient-based optimization, e.g., sequential quadratic programming, or others. In order to use f = ((Uc(t)-U0)/[1/C * int_s(i(s)ds)] - 1)^2 as objective function, the current i is numerically integrated to obtain int_s(i(s)). Instead of f any other suitable function can be used, as for example a square root of f. In some applications also f'= ∥ (Uc(t)-U0)/[1/C * int_s(i(s)ds)]∥_2 can be considered.

In a fourth step 104 an abnormal value of the capacitance is detected. The capacitance value of the capacitor is compared with capacitance values of other capacitors of the same converter arm of the MMC. If the capacitance value of the capacitor is lower than an average of capacitance values of all capacitors of the same converter arm minus a predefined gap value, then the capacitance value is recorded as abnormal. In addition, the capacitance value is compared with past capacitance values of the capacitor: the capacitance value is recorded as abnormal if the capacitance value decreases faster than a predefined decrease threshold.

In a fifth step 105 the determination of the capacitance is repeated after a predefined time (e.g., several hours or days).

In a sixth step 106, if an abnormal capacitance is detected repeatedly (i.e. subsequently a predefined number of times), a corresponding information is provided to a converter monitoring system. According to this information it can be decided (e.g. by a superordinated control or a human supervisor) to take a maintenance action.

## Claims

1. Method for operating a converter (1,7), said converter (1,7) comprising at least one switching module (12), said switching module (12) comprising an energy storage (C) and semiconductor switches (S1,S2) to allow and/or to block current flow through said energy storage (C), said method comprising the steps of
- measuring a voltage present across said energy storage (C),
- measuring current flowing through said energy storage (C),
**characterized in**
- determining a capacitance of said energy storage (C) by minimizing an objective function of said voltage, said current, said capacitance and a time over minimization parameters capacitance and time.

2. Method of claim 1, wherein said objective function depends on a time integral of said current.

3. Method of one of the preceding claims, wherein the minimization parameters are constrained within predefined parameter limits.

4. Method of one of the preceding claims, wherein the measured voltage and/or current values are smoothed before determining the capacity.

5. Method of one of the preceding claims, wherein said method comprises a step of identifying an offset in the measured current before determining the capacitance.

6. Method of one of the preceding claims, wherein the method further comprises the step of detecting an abnormal capacitance value.

7. Method of the preceding claim 6, wherein said detecting abnormal capacitance value considers a long-term capacitance value drift.

8. Method of one of the preceding claims, wherein the method steps are repeated several times a day.

9. Converter (1,7) for converting electrical power, the converter comprising a converter control (13) configured to operate the converter in accordance with the method of claims 1 to 8.

10. Converter (1,7) according to claim 9, wherein the converter (1,7) is a modular multilevel converter having a series of switching modules (12) each comprising an energy storage (C), wherein the converter control (13) is configured to determine a capacitance of all energy storages (C).

## Patentansprüche

1. Verfahren zum Betreiben eines Umrichters (1, 7), wobei der Umrichter (1, 7) mindestens ein Schaltmodul (12) umfasst, wobei das Schaltmodul (12) einen Energiespeicher (C) und Halbleiterschalter (S1, S2) umfasst, um einen Stromfluss durch den Energiespeicher (C) zu ermöglichen und/oder zu blockieren, wobei das Verfahren die folgenden Schritte umfasst:
- Messen einer Spannung, die an dem Energiespeicher (C) anliegt,
- Messen eines Stroms, der durch den Energiespeicher (C) fließt,
**gekennzeichnet durch**
- Bestimmen einer Kapazität des Energiespeichers (C) durch Minimieren einer Zielfunktion der Spannung, des Stroms, der Kapazität und einer Zeit über den Minimierungsparametern Kapazität und Zeit.

2. Verfahren nach Anspruch 1, wobei die Zielfunktion von einem Zeitintegral des Stroms abhängt.

3. Verfahren nach einem der vorhergehenden Ansprüche, wobei die Minimierungsparameter innerhalb vordefinierter Parametergrenzen eingeschränkt sind.

4. Verfahren nach einem der vorhergehenden Ansprüche, wobei die gemessenen Spannungs- und/oder Stromwerte vor dem Bestimmen der Kapazität geglättet werden.

5. Verfahren nach einem der vorhergehenden Ansprüche, wobei das Verfahren einen Schritt des Identifizierens eines Versatzes in dem gemessenen Strom vor dem Bestimmen der Kapazität umfasst.

6. Verfahren nach einem der vorhergehenden Ansprüche, wobei das Verfahren ferner den Schritt von Erfassen eines anormalen Kapazitätswerts umfasst.

7. Verfahren nach dem vorhergehenden Anspruch 6, wobei das Erfassen eines anormalen Kapazitätswerts eine Drift eines langfristigen Kapazitätswerts berücksichtigt.

8. Verfahren nach einem der vorhergehenden Ansprüche, wobei die Verfahrensschritte mehrmals am Tag wiederholt werden.

9. Umrichter (1, 7) zum Umrichten von elektrischer Leistung, wobei der Umrichter eine Umrichtersteuerung (13) umfasst, die dazu konfiguriert ist, den Umrichter gemäß dem Verfahren nach den Ansprüchen 1 bis 8 zu betreiben.

10. Umrichter (1, 7) nach Anspruch 9, wobei es sich bei dem Umrichter (1, 7) um einen modularen Mehrstufenumrichter handelt, der eine Reihe von Schaltmodulen (12) aufweist, die jeweils einen Energiespeicher (C) umfassen, wobei die Umrichtersteuerung (13) dazu konfiguriert ist, eine Kapazität von sämtlichen Energiespeichern (C) zu bestimmen.

## Revendications

1. Procédé de fonctionnement d'un convertisseur (1,7), ledit convertisseur (1,7) comprenant au moins un module de commutation (12), ledit module de commutation (12) comprenant un stockage d'énergie (C) et des commutateurs à semi-conducteur (S1,S2) pour permettre et/ou bloquer une circulation de courant à travers ledit stockage d'énergie (C), ledit procédé comprenant les étapes de
- la mesure d'une tension présente aux bornes dudit stockage d'énergie (C),
- la mesure d'un courant circulant à travers ledit stockage d'énergie (C),
**caractérisé par**
- la détermination d'une capacité dudit stockage d'énergie (C) par la minimisation d'une fonction objective de ladite tension, dudit courant, de ladite capacité et d'un temps sur des paramètres de minimisation de capacité et de temps.

2. Procédé selon la revendication 1, dans lequel ladite fonction objective dépend d'une intégrale temporelle dudit courant.

3. Procédé selon l'une quelconque des revendications précédentes, dans lequel les paramètres de minimisation sont contraints dans des limites de paramètres prédéfinies.

4. Procédé selon l'une quelconque des revendications précédentes, dans lequel les valeurs mesurées de tension et/ou de courant sont lissées avant la détermination de la capacité.

5. Procédé selon l'une quelconque des revendications précédentes, dans lequel ledit procédé comprend une étape d'identification d'un décalage dans le courant mesuré avant la détermination de la capacité.

6. Procédé selon l'une quelconque des revendications précédentes, dans lequel le procédé comprend en outre l'étape de détection d'une valeur de capacité anormale.

7. Procédé selon la revendication 6 précédente, dans lequel ladite détection d'une valeur de capacité anormale prend en compte une dérive de valeur de capacité à long terme.

8. Procédé selon l'une quelconque des revendications précédentes, dans lequel les étapes du procédé sont répétées plusieurs fois par jour.

9. Convertisseur (1,7) pour la conversion de puissance électrique, le convertisseur comprenant un dispositif de commande de convertisseur (13) configuré pour faire fonctionner le convertisseur conformément au procédé selon l'une quelconque des revendications 1 à 8.

10. Convertisseur (1,7) selon la revendication 9, dans lequel le convertisseur (1,7) est un convertisseur multiniveau modulaire ayant une série de modules de commutation (12) comprenant chacun un stockage d'énergie (C), dans lequel le dispositif de commande de convertisseur (13) est configuré pour déterminer une capacité de tous les stockages d'énergie (C).
